# DEMANDE DE BREVET EUROPEEN

(11) **EP 1 172 958 A1**
(43) Date de publication de la demande: **16.01.2002**
(21) Numéro de dépôt: 01202556.5
(22) Date de dépôt: 03.07.2001
(51) Int. Cl.: H04L 1/00, H04N 7/50

(54) **Système de communication, émetteur, mèthode de protection contre des erreurs de transmission**

(30) Priorité: 11.07.2000 FR 0009049
(71) Demandeur: Koninklijke Philips Electronics N.V., 5621 BA Eindhoven (NL)
(72) Inventeur: Bonifas, Jean-Luc, 75008 Paris (FR)
(74) Mandataire: Chaffraix, Jean

(57) **Abrégé**

L'invention concerne une méthode de protection contre des erreurs de transmission, de trames de données primaires numériques comprenant des données primaires de priorités différentes, pour délivrer sur un canal de communication des trames de données protégées contre les erreurs de transmission. Un niveau de priorité relatif aux données primaires est déterminé pour d'une part en informer l'étape de protection effectuant la protection contre les erreurs, et pour d'autre part prendre une décision portant sur la nécessité de protéger lesdites données primaires. L'étape de protection du type FEC contre les erreurs permet de délivrer lesdites données protégées à partir desdites données primaires, en ajoutant à chaque type de données primaires une quantité d'information de redondance tenant compte à la fois de leur niveau de priorité et d'une valeur renseignant sur la qualité du canal de communication.

Application : Protection de données contre les erreurs

## Description

L'invention concerne une méthode de protection contre des erreurs de transmission, de trames de données primaires numériques comprenant des données primaires de priorités différentes, pour délivrer sur un canal de communication des trames de données protégées contre les erreurs de transmission.
Elle concerne également un système de communication incluant un émetteur pour transmettre des trames de données primaires numériques à un récepteur via un canal de communication, cet émetteur étant pourvu de moyens adaptés pour mettre en oeuvre la méthode précédemment mentionnée.
Elle a de nombreuses applications dans les systèmes de communication de données multimédias en général, comme c'est notamment le cas dans les applications de type vidéophonie sur réseaux mobiles ou filaires.

Le brevet européen publié sous le numéro 0 680 157 A1 décrit une méthode et un système pour contrôler la protection aux erreurs des données transmises à partir d'un émetteur à un récepteur, sur une voie de transmission. Cette méthode met en oeuvre une protection des données à transmettre en utilisant au mieux la bande passante disponible sur la voie de transmission. Pour cela, les données à transmettre sont dans un premier temps classées suivant différents niveaux d'importance, et sont dans un second temps encodées selon un algorithme ayant pour but de leur ajouter des données de redondance. Cet ajout de données de redondance tient compte du niveau d'importance des données à transmettre afin de faire varier la puissance de protection.
La méthode de protection contre les erreurs de transmission mise en oeuvre dans le document de l'art antérieur présente un certain nombre d'inconvénients.
Tout d'abord, la puissance de protection est définie à l'avance, si bien que cette méthode ne prend pas en compte d'éventuels changements relatifs à la qualité de transmission pouvant remettre en question la puissance de protection des données à transmettre. Cette méthode souffre donc d'un manque d'adaptation de la protection des données à des conditions fluctuantes de transmission, ce qui se traduit dans ces conditions d'une part par une mauvaise occupation de la bande passante de la voie de transmission, mais aussi par une mauvaise protection des données transmises.
D'autre part, la méthode décrite implique la mise en oeuvre d'une architecture rigide nécessitant de définir à l'avance le nombre de niveaux d'importance des données à protéger. Cette rigidité de l'architecture se traduit par la mise en oeuvre d'une chaîne de traitement des données, pour chacun des niveaux d'importance. Il y a donc autant de chaîne de traitement qu'il y a de niveaux d'importance, ce qui conduit à une solution coûteuse et peu flexible.

L'invention a pour but de remédier dans une large mesure à ces inconvénients en proposant un système de communication, un émetteur, ainsi qu'une méthode, ayant pour but de protéger de façon sélective des trames de données primaires transmises sur un canal de communication, d'une façon plus fiable et moins coûteuse que celle décrite dans le document de l'art antérieur.

A cet effet, la présente invention est caractérisée en ce que la méthode de protection comprend des moyens d'attribution d'un niveau de priorité à chacune des trames de données primaires, et des moyens de protection de type FEC contre les erreurs de transmission pour ajouter des paquets de données de redondance aux trames de données primaires pour lesquelles une protection est envisagée, la quantité de données de redondance étant fonction du niveau de priorité de la trame primaire considérée et du taux d'erreurs du canal de communication, lesdits moyens de protection délivrant lesdites trames de données protégées sur le canal de communication.

La méthode de protection selon l'invention comporte un ensemble générique d'étapes de traitement conduisant à délivrer des données protégées contre des erreurs de transmission sur un canal de communication. Cet ensemble d'étapes de traitement est appliqué à toutes les données primaires faisant l'objet d'une protection contre les erreurs. Dans un premier temps, les données primaires étant supposées être de plusieurs types, une détection de leur type est effectuée. A l'aide d'une table de correspondance, une priorité relative aux données primaires est alors déterminée pour d'une part en informer l'étape de protection effectuant la protection contre les erreurs, et pour d'autre part prendre une décision portant sur la possibilité ou la nécessité de protéger lesdites données primaires. En effet, l'étape de protection contre les erreurs de transmission consistant à ajouter des informations de redondance aux données primaires, il est ainsi possible de ne pas protéger les données d'un certain type s'il est jugé que cela conduirait à une augmentation trop importante des données transmises sur le canal de communication, ou s'il est jugé que la priorité des données est suffisamment basse pour s'affranchir d'une protection contre les erreurs. L'étape de protection aux erreurs, du type FEC (de l'anglais Forward Error Correction), permet de délivrer lesdites données protégées à partir desdites données primaires, de leur priorité associée et d'une valeur renseignant sur la qualité du canal de communication. Cette étape de protection de type FEC, par exemple selon la norme IETF RFC 2733 dans le contexte de transmission de paquets RTP (de l'anglais Real-Time Transport Protocol), permet d'ajouter à chaque type de données primaires une quantité d'informations de redondance tenant compte à la fois de leur priorité et de ladite valeur renseignant sur la qualité du canal de communication. En effet, la quantité d'informations de redondance est d'autant plus grande que la priorité des données primaires est élevée et que la qualité du canal de communication est mauvaise. La méthode décrite est ainsi générique puisqu'une seule chaîne de traitement est mise en oeuvre quel que soit le type de données primaires à traiter, peu coûteuse puisque l'on ne multiplie pas les chaînes de traitement en fonction des différents types de données primaires, et flexible puisque le nombre de données de redondance ajoutées aux données primaires est adapté à la qualité courante du canal de communication.

L'invention concerne également un émetteur inclus dans un système de communication de type radiotéléphonie par exemple, dont le fonctionnement pourra bénéficier des possibilités de protection contre les erreurs décrites ci-dessus. L'invention prévoit en effet un ensemble générique de traitement desdites données primaires pour transmettre à un récepteur des données protégées contre des erreurs de transmission. L'émetteur règle ainsi le niveau de redondance des données envoyées de façon adaptée au niveau de priorité des données et à la qualité du canal de transmission, tout en garantissant un compromis optimal entre l'occupation de la bande passante du canal de transmission et le niveau de protection contre les erreurs.

Ces aspects de l'invention ainsi que d'autres aspects plus détaillés apparaîtront plus clairement grâce à la description suivante, faite en regard des dessins ci-annexés, le tout donné à titre d'exemple non limitatif, dans lesquels :
La figure 1 est un schéma fonctionnel décrivant l'enchaînement des différentes opérations selon l'invention,
La figure 2 est un schéma décrivant un système de communication comprenant un émetteur selon l'invention.

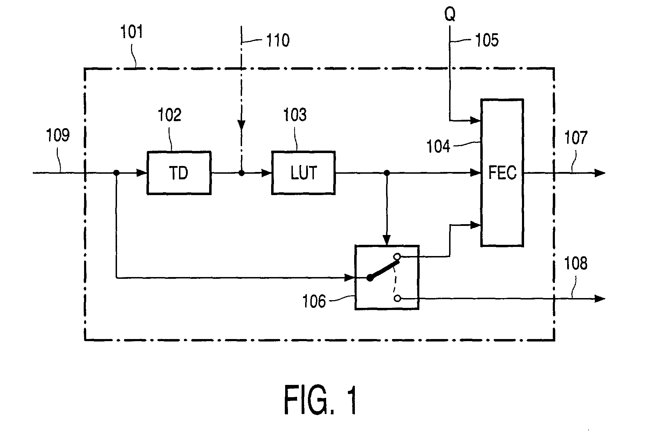

La figure 1 décrit schématiquement les différentes étapes conduisant à la protection des données primaires envoyées par un émetteur sur un canal de communication. L'ensemble 101 des différentes étapes permet de délivrer, à partir de données primaires 109, des données 107 protégées contre les erreurs de transmission et/ou des données 108 n'ayant subi aucun traitement de protection contre les erreurs. Les données primaires 109 correspondent à des trames de données numériques issues d'un encodeur audio/vidéo par exemple, ou de façon plus générale issues d'une source de données numériques de données multimédias. Ces trames de données primaires sont par exemple issues d'un encodeur audio/vidéo de la famille MPEG-1/MPEG-2 /MPEG-4/H.263 ou d'applications utilisant les normes H.323/H.324. Ce type de données présente la caractéristique de comprendre des types différents de données permettant de les identifier et de les synchroniser lors de leur décodage. Dans le contexte de l'invention, ces différents types de données sont interprétés et traduits en niveaux de priorité. En effet, il existe une certaine hiérarchie de telles données qui permet de décrire le contenu informationnel délivré par ladite source. Par exemple, si les données primaires 109 sont relatives à des données vidéo encodées selon la norme MPEG-2 ou MPEG-4, les données de type Video Object (VO), Video Object Layer (VOL), Group of Video plane (GOV), Video Object Plane (VOP) et Video Packet (VP) définissent une structure hiérarchique imbriquée de priorité décroissante dans laquelle il est préférable de protéger contre les erreurs les données relatives aux images, c'est-à-dire aux données ayant le type le plus prioritaire. Pour cela, il est prévu une étape 102 de détection du type des données ou trames de données primaires 109 afin de leur associer un niveau de priorité. Cette détection se base sur l'analyse de la syntaxe d'encodage des données primaires 109, en repérant notamment des mots-clés de la syntaxe contenus dans les différents entêtes (Headers en anglais). Dans une autre variante de l'invention, il pourra être envisagé de ne pas faire de détection du type des données 109, cette information de type étant directement fournie par des éléments extérieurs, tels que l'encodeur ou la source délivrant les données 109. Cette variante est référencée en 110. Une fois que le type des données primaires est connu, une correspondance est établie à l'étape 103 entre ladite information de type et un niveau de priorité. Cette étape, davantage détaillée par la suite, consiste en la mise en oeuvre d'une table de correspondance dans laquelle un utilisateur a préalablement établi une correspondance entre chaque type de données et un niveau de priorité. Le nombre de correspondances n'étant limité par aucune contrainte, cette méthode peut dès ce niveau de traitement être adaptée à différentes sources de données contenant des types de données en nombre différent. Il suffit pour cela de prévoir une table de correspondance comportant un nombre de correspondances suffisamment grand, quitte à ne pas toutes les utiliser si les données primaires comportent un faible nombre de types. L'étape 103 délivre ainsi une valeur relative à la priorité des données ou trames de données primaires 109. Suivant la valeur de ce niveau de priorité, les données 109 sont effectivement protégées contre les erreurs de transmission, ou alors ne subissent aucun traitement supplémentaire. L'élément 106 est chargé de ce choix permettant l'orientation des données primaires 109 dans la chaîne de traitement 101. Il peut en effet être décidé de ne pas protéger les données primaires dont la priorité est faible, cela signifiant que l'on est soit en présence de données de faible importance ne justifiant pas une protection, soit de données pouvant être reconstruites après transmission même après avoir subi de nombreuses erreurs. Dans ces cas, les données 109 ne sont pas protégées contre les erreurs afin de ne pas surcharger inutilement la bande passante du canal de communication sur lequel sont envoyées les données primaires. Dans le cas contraire où la priorité des données primaires est jugée suffisamment élevée, l'élément 106 aiguille les données 109 vers l'étape 104 de protection contre les erreurs. Cette étape de protection a pour but d'ajouter des données de redondance aux données primaires 109 pour pouvoir reconstruire ces mêmes données primaires après transmission, même si celles-ci subissent de nombreuses erreurs lors de leur transmission. L'étape 104 permet de délivrer des données 107 protégées contre les erreurs de transmission en mettant en oeuvre de façon spécifique et innovante un algorithme de type FEC. L'invention prévoit à cet effet une protection sélective des données primaires dans le sens où la quantité de redondance, exprimée par exemple en pourcentage du volume en octets des données primaires auxquelles s'applique cet ajout de redondance, tient compte de la priorité des données primaires. En d'autres termes, le pourcentage de redondance ajoutée aux données primaires sera d'autant plus grand que le niveau de priorité sera élevé. Cet aspect de l'invention sera davantage détaillé par la suite. De cette façon, il est à la fois possible de garantir une protection optimale des données importantes, tout en ne transmettant pas sur le canal de communication des données de redondance ajoutées à des données primaires de faible niveau de priorité, le canal de communication n'étant pas alors inutilement encombré. L'étape de protection 104 reçoit, en plus des données 109 et de la valeur renseignant sur leur niveau de priorité, une valeur 105 reflétant la qualité Q du canal de transmission. Cette valeur reflète par exemple le taux d'erreurs du canal de communication estimé par le nombre de trames de données perdues sur ce canal pendant une certaine durée, cette estimation étant faite au niveau d'un dispositif distant et le résultat de cette étape d'estimation envoyé à l'émetteur. De cette façon, la quantité de redondance ajoutée aux données primaires est modulée par cette valeur de qualité du canal de communication : la quantité de redondance ajoutée aux données primaires est d'autant plus élevée que cette valeur de qualité reflète un taux d'erreurs important. Les données primaires ne sont ainsi pas protégées suivant une valeur arbitraire de la qualité du canal de communication, mais suivant une valeur de qualité reflétant les caractéristiques réelles dudit canal : le degré de protection est parfaitement adapté aux conditions de transmission des données.

La protection contre les erreurs de transmission est ainsi assurée par une double stratégie menée conjointement pour permettre de quantifier les données de redondance à ajouter aux données primaires, cette stratégie comprenant :
- une évaluation d'une première quantité de données de redondance (paquets FEC) faite suivant le niveau de priorité des données primaires, cette première quantité étant d'autant plus importante que le niveau de priorité est élevé,
- une modulation de cette première quantité de données de redondance (paquets FEC) faite suivant une valeur reflétant la fiabilité et la qualité du canal de communication, cette modulation se traduisant par une augmentation d'autant plus grande des données de redondance que le canal de communication est peu fiable ou que le taux d'erreurs de transmission est élevé, cette augmentation des données de redondance étant bien sûr limitée par la bande passante maximale du canal de transmission.

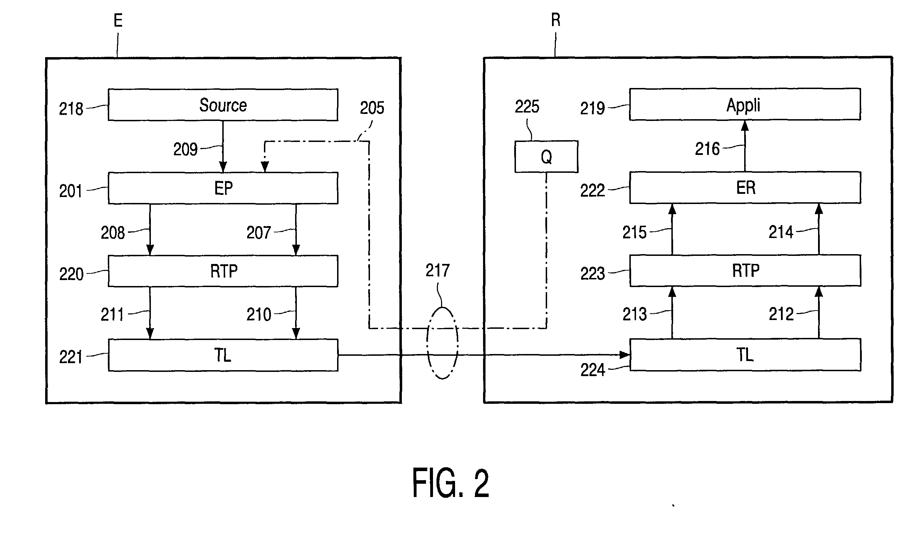

La figure 2 décrit un système de communication comprenant un émetteur selon l'invention. Ce système de communication comprend un émetteur E communiquant via un canal de communication 217 de type filaire ou hertzien, avec un récepteur R recevant les données protégées en vue de les utiliser dans des applications de type multimédia par exemple. Ce système de communication correspond par exemple à une application de « streaming video » (« envoi d'information vidéo » en anglais), de vidéo à la demande ou à une application de vidéo téléphonie utilisant la norme H.323 (utilisant le protocole de transmission RTP) relative à la transmission de vidéo sur Internet, ou à la norme H.324 (utilisant le protocole de transmission de la norme H.223) relative à une application de type vidéotéléphonie, ou à une application de type GSM, ou à une application mettant en oeuvre la norme Bluetooth.

L'émetteur E comprend une source 218 de données ou de trames de données primaires numériques 209 issues par exemple d'un serveur ou d'un encodeur audio/vidéo, et envoyées au module de protection contre les erreurs 201. Parallèlement à ces données primaires, le module 201 reçoit un signal 205 renseignant sur la qualité du canal de transmission 217. A cet effet, il est possible d'exploiter le protocole RTCP (de l'anglais RTP Control Protocol), défini conjointement avec le protocole RTP selon la norme RCF 1889 IETF, pour utiliser les statistiques qu'il permet de délivrer portant sur la qualité de la communication, telles que le nombre de paquets de données perdus depuis le dernier paquet RTCP reçu au niveau du récepteur R. Cette estimation de la qualité du canal de communication est effectuée par le bloc 225 qui transmet à l'émetteur le résultat de son estimation via le signal 205. Bien sûr, tout autre moyen, un moyen propriétaire par exemple, pourra être mis en oeuvre pour délivrer une information 205 reflétant la qualité du canal de transmission. Le module 201, selon la description faite en regard de la figure 1, délivre à partir des données primaires 209, soit des données sans protection 208, soit des données 207 protégées par l'ajout de données de redondance, le degré de protection des données primaires dépendant à la fois de leur niveau de priorité et de la qualité de transmission 217. Par la suite, la description sera faite de façon non restrictive sur la base d'une application selon le protocole RTP.

Dans un mode de réalisation préféré, considérons un système de communication pouvant effectuer l'envoi de données encodées selon la norme MPEG-4 entre un émetteur selon l'invention et un récepteur, via un canal de communication utilisant la norme Bluetooth. Dans ce cas, de façon non restrictive, les données vidéo de type GOV (de l'anglais Group of Video Object Plane), les données d'estimation de mouvement MV (de l'anglais Motion Vector), et les données de TEXTURE constituent trois types de données de priorité p() décroissante telle que p(GOV) > p(MV) > p(TEXTURE) pour lesquelles une protection selon l'invention contre les erreurs de transmission est envisagée. Il peut être donné un haut niveau de priorité au type GOV, un niveau moyen de priorité au type MV, et un niveau bas de priorité au type TEXTURE en considérant que les données correspondantes à ce dernier type ne sont pas indispensables à l'application et que des erreurs ou des pertes de ces données ne sont que faiblement dommageables. Ainsi, trois degrés de protection des données primaires sont définis par le module 201 pour une certaine qualité Q1 du canal de communication :
a) ajout de 100 % de données de redondance aux données de type GOV,
b) ajout de 50 % de données de redondance aux données de type MV,
c) ajout de 5 % de données de redondance aux données de type TEXTURE.
Avec une qualité Q2 de transmission sur le canal de communication, plus mauvaise que dans le scénario précédent, c'est-à-dire avec Q2 < Q1, les trois degrés de protection des données primaires sont maintenant définis par :
a) ajout de 200 % de données de redondance aux données de type GOV,
b) ajout de 60 % de données de redondance aux données de type MV,
c) aucun ajout de données de redondance aux données de type TEXTURE.

Cet exemple illustre parfaitement la double stratégie décrite précédemment pour permettre de quantifier les données de redondance à ajouter aux données primaires, dans le sens où le volume de données de redondance dépend non seulement de la priorité des données mais aussi de la qualité du canal de communication : ici, dans le cas où Q=Q2, et comparativement au cas où Q=Q1, les données de redondance sont principalement renforcées sur les données de type GOV, contrairement aux données de type MV dont la quantité de redondance n'augmente que faiblement, d'une part parce qu'elles n'ont pas un niveau de priorité élevé, et d'autre part pour ne pas saturer le canal de communication. Quant aux données de type TEXTURE, aucune donnée de redondance n'est ajoutée dans le cas où Q=Q2 puisque leur niveau de priorité est le plus faible et que tout l'effort de protection est mis sur les données de type GOV. Les données de type TEXTURE sont envoyées sans protection contre les erreurs sur le canal de communication, cet envoi pouvant être fait par le module de protection FEC (sans ajout de données de redondance) ou par simple aiguillage des données primaires sur ledit canal de communication.

De façon similaire aux données GOV, MV et TEXTURE, d'autres données ayant des priorités différentes peuvent faire l'objet d'une protection sélective contre les erreurs avant leur envoi sur le canal de communication. Dans le contexte de la norme MPEG-4, ou plus généralement dans le contexte des normes de compression vidéo MPEG, il est en effet judicieux de prévoir une protection sélective des données appartenant aux différents types d'images I, P et B. Le type I est dédié aux images INTRA pour lequel aucune compensation de mouvement n'est effectuée. Les images de type I servent de référence pour la prédiction temporelles des autre images dans la séquence, si bien qu'un haut niveau de priorité leur est associé. Le type P est dédié aux images pour lesquelles une prédiction temporelle est effectuée afin de tirer profit de la redondance temporelle existant entre deux images consécutive d'un séquence vidéo, et ainsi augmenter le taux de compression vidéo. Les images de type P sont codées en référence à une image de référence de type I. Un niveau moyen de priorité leur est associé. Le type B est dédié aux images pour lesquelles une double prédiction temporelle est effectuée afin d'obtenir un taux de compression maximum de ces images. Un niveau faible de priorité leur est associé dans la mesure où ces images peuvent être, en cas de dégradation lors de leur transmission, interpolées à partir des images de types I et P.

Ainsi, dans le cadre d'une protection sélective de type FEC contre les erreurs de transmission, trois niveau de protection prenant en compte le niveau de priorité des données de type I, P et B sont effectués :
a) Ajout important de données de redondance aux données définissant des images de type I, la protection contre les erreurs étant faite par la concaténation d'un nombre important de données de redondance (paquets FEC) aux données primaires définissant les images de type I. De façon avantageuse, il peut également être envisagé qu'un paquet FEC protégeant contre les erreurs des données importantes, ne contienne qu'un nombre réduit de paquets FEC combinés dans son masque.
b) Faible ajout de données de redondance aux données définissant des images de type P, cet ajout de données de redondance étant fait par la concaténation d'un faible nombre de paquets FEC aux données primaires définissant les images de type P.
c) Aucun ajout de données de redondance aux données primaires définissant les images de type B.

Ces données analysées et/ou traitées par 201 sont alors envoyées vers le module 220 ayant pour fonction de les formater selon le protocole RTP, notamment en ajoutant à chacune des trames de données un entête RTP spécifique à la protection FEC afin de synchroniser les données primaires et les données de redondance correspondantes au niveau du récepteur. Le module 220 envoie ainsi des trames de données 210 et 211 formatées selon le protocole RTP, à partir des données 207 et 208 respectivement. Chacune des trames de données 210 et 211 est envoyée sur le canal de communication 217 via la couche de transport 221.

De façon avantageuse, l'ajout de données de redondance aux données primaires à transmettre sur un canal de communication peut être contraint par les caractéristiques dudit canal. En effet, un canal de communication ayant toujours une bande passante limitée, l'ajout de données de redondance (paquets FEC) doit être tel que le débit des données protégées contre les erreurs doit être en permanence inférieure où égale à celle du canal de communication, même en cas de fluctuation de la bande passante dudit canal de communication. Le débit des données protégées contre les erreurs peut être vu comme la somme du débit des données primaires et du débit des données de redondance. Connaissant le taux d'erreurs de transmission sur le canal 217, un débit des données de redondance à associer aux données primaires est déterminé afin d'avoir à la réception une correction maximale des erreurs détectées (taux de recouvrement maximal), cette détermination pouvant se faire de façon expérimentale ou au moyen d'abaques paramétrées par le taux d'erreurs de transmission et reliant le débit des données de redondance au taux de recouvrement souhaité. Le débit des données de redondance ainsi déterminé est maintenu constant dans le temps tant que les ledit taux d'erreurs de transmission ne change pas, sinon, une nouvelle détermination est faite dynamiquement pour tenir compte des conditions réelles du canal de communication.
Selon une première stratégie, lorsque la bande passante maximum dudit canal de communication diminue, ce qui est le cas par exemple si le réseau de communication est saturé, le débit 209 des données primaires issues de 218 est automatiquement ajusté par un contrôleur situé au niveau de l'émetteur de sorte à ce que la somme du débit des données primaires et du débit des données de redondance soit toujours égale à ladite bande passante maximum du canal de communication. Cet ajustement du débit 209 par ledit contrôleur, dans le cas où la source 218 génère un signal vidéo comprimé selon la norme MPEG-4, est obtenu en augmentant les pas de quantification des blocs DCT (de l'anglais Discrete Cosine Transform). Inversement, lorsque la bande passante maximum dudit canal de communication augmente, ledit contrôleur effectue une augmentation du débit 209 en diminuant les pas de quantification des blocs DCT, pour remplir de façon optimale et maximale la bande passante du canal de communication.
Selon une deuxième stratégie, de sorte à ce que la somme du débit des données primaires et du débit des données de redondance soit toujours égale à ladite bande passante maximum du canal de communication, ledit contrôleur met en oeuvre une technique de scalabilité temporelle. Cette technique consiste pour le contrôleur à indiquer à la source 218 quelles données primaires peuvent ne pas être envoyées sur le canal de communication. Ainsi, en cas de diminution de la bande passante maximale du canal de communication ou de l'augmentation du taux d'erreur de transmission, c'est à dire lorsqu'il faut réduire le débit des données primaires 209, les données primaires de faibles niveau de priorité ne sont pas transmises sur le canal de communication.
Selon une troisième stratégie, de sorte à ce que la somme du débit des données primaires et du débit des données de redondance soit toujours égale à ladite bande passante maximum du canal de communication, ledit contrôleur met en oeuvre une technique de sélection parmi un ensemble de flux de données primaires ayant des débits différents. Dans ce contexte, la source 218 ne délivre plus un mais plusieurs flux de données 209 synchrones ayant des débits différents, par exemple un premier flux de débit D1 et un deuxième flux de débit D2, avec D1 < D2, lesdits flux provenant d'une même séquence vidéo originale et étant encodés en parallèle avec deux encodeurs vidéo séparés, ou bien étant pré-encodés puis stockés sur une unité de stockage (e.g. disque dur). Ainsi, lorsque le débit des données primaires doit être diminué, le contrôleur sélectionne un flux de données primaires 209 de débit plus faible, passant par exemple du débit D2 à D1. Inversement, lorsque le débit des données primaires peut être augmenté, le contrôleur sélectionne un flux de données primaires 209 de débit plus élevé, passant alors du débit D1 à D2.
Au niveau du récepteur R, les trames de données reçues via la couche de transport 224 sont divisées en deux classes : les trames de données 213 n'ayant subi aucune protection contre les erreurs, et les trames de données 212 ayant fait l'objet d'une protection de type FEC contre les erreurs. Envoyées au module 223, les trames de données 212 et 213 sont analysées en vue de supprimer leur syntaxe associée relative au protocole RTP, ladite syntaxe servant à synchroniser les différentes trames de données reçues. Le module 223 délivre ainsi au module 222, des trames de données 215 exemptes de protection, et des trames de données 214 contenant à la fois des données primaires et des données de redondance. A ce niveau, les trames 215 et 214 correspondent aux trames 208 et 207 respectivement, sauf si des erreurs sont survenues lors de la transmission sur le canal 217, d'où le module 222 ayant pour objet de reconstruire les données entachées d'erreurs
- soit à partir des seules données 215 non protégées de contenu ayant un faible niveau de priorité, principalement à partir d'interpolation sur des données précédemment reçues non corrompues,
- soit en utilisant les données de redondance associées aux trames de données 214, en appliquant un algorithme de type FEC décrit par la norme RFC 2733. Bien sûr, la réussite de cette reconstruction des données primaires envoyées sera d'autant plus probable que le rapport correspondant au nombre d'erreurs présentes sur la quantité de données de redondance sera faible.

Les données 216 ainsi reconstruites et exemptes d'erreurs sont alors envoyées à une application 219, par exemple pour être décodées et affichées sur un écran s'il s'agit de données de type vidéo.

Les différentes étapes selon l'invention permettant de délivrer des trames de données protégées peuvent être implémentées au niveau de l'émetteur de différentes façons, notamment en utilisant un processeur de signal exécutant un jeu d'instructions relatif aux traitements 102/106/104 opérés sur des trames de données primaires, et en utilisant une mémoire dont le contenu permet d'établir la correspondance type/priorité relative à l'étape 103.

Ainsi ont été décrits et illustrés un système de communication, un émetteur, ainsi qu'une méthode permettant de protéger de façon sélective contre les erreurs, des données transmises sur un canal de communication sujet aux erreurs. Bien entendu, de nombreuses variantes pourront être apportées aux modes de réalisation décrits sans sortir du cadre de l'invention.

## Revendications

1. Emetteur comportant des moyens de génération de trames de données primaires numériques, pour transmettre à un récepteur via un canal de communication lesdites trames de données primaires numériques protégées contre des erreurs de transmission, **caractérisé en ce que** l'émetteur comprend des moyens d'attribution d'un niveau de priorité à chacune des trames de données primaires, et des moyens de protection de type FEC contre les erreurs de transmission pour ajouter des paquets de données de redondance aux trames de données primaires pour lesquelles une protection est envisagée, la quantité de données de redondance étant fonction du niveau de priorité de la trame primaire considérée et du taux d'erreurs du canal de communication, lesdits moyens de protection délivrant lesdites trames de données protégées sur le canal de communication.

2. Emetteur selon la revendication 1 **caractérisé en ce que** les paquets de données de redondance associés aux trames de données primaires sont d'autant plus nombreux que le niveau de priorité desdites trames de données primaires est élevé et que le taux d'erreurs du canal est élevé.

3. Emetteur selon la revendication 2 **caractérisé en ce que** l'attribution d'un niveau de priorité à chacune des trames de données primaires est faite en deux temps, tout d'abord par une identification du type de données contenues dans chacune des trames de données primaires, puis par la mise en correspondance, au moyen d'une table de correspondance stockée en mémoire, dudit type de données avec un niveau de priorité.

4. Emetteur selon la revendication 3 **caractérisé en ce que** qu'il comprend des moyens de contrôle ayant pour fonction de s'assurer, par action sur lesdits moyens de génération des trames de données primaires, que le débit des trames de données primaires numériques protégées envoyées sur le canal de communication n'excède pas la bande passante maximale dudit canal de communication.

5. Emetteur selon la revendication 4 **caractérisé en ce que** lesdits moyens de génération de trames de données primaires numériques délivrent un flux de données primaires unique dont le débit est contrôlé par lesdits moyens de contrôle.

6. Emetteur selon la revendication 5 **caractérisé en ce que** lesdits moyens de contrôle empêche la transmission de certaines trames de données primaires, notamment celles dont le niveau de priorité est faible.

7. Emetteur selon la revendication 6 **caractérisé en ce que** lesdits moyens de génération de trames de données primaires numériques délivrent plusieurs flux de données primaires synchrones ayant chacun un débit différent, lesdits moyens de contrôle sélectionnant alternativement, dans ces différents flux, des trames de données primaires à protéger contre les erreurs de protection.

8. Equipement téléphonique comportant un émetteur selon la revendication 1.

9. Procédé d'émission de données comportant une étape de génération de trames de données primaires numériques, pour transmettre à un récepteur via un canal de communication lesdites trames de données primaires numériques protégées contre des erreurs de transmission, **caractérisé en ce que** le procédé comprend aussi:
- une étape d'attribution d'un niveau de priorité à chacune des trames de données primaires,
- une étape de protection de type FEC contre les erreurs de transmission pour ajouter des paquets de données de redondance aux trames de données primaires pour lesquelles une protection est envisagée, la quantité de données de redondance étant fonction du niveau de priorité de la trame primaire considérée et du taux d'erreurs du canal de communication,
ladite étape de protection délivrant lesdites trames de données protégées sur le canal de communication.

10. Procédé d'émission de données selon la revendication 9 **caractérisé en ce que** les paquets de données de redondance associés aux trames de données primaires sont d'autant plus nombreux que le niveau de priorité desdites trames de données primaires est élevé et que le taux d'erreurs du canal est élevé.

11. Procédé d'émission de données selon la revendication 10 **caractérisé en ce que** l'attribution d'un niveau de priorité à chacune des trames de données primaires est faite par une première étape d'identification du type de données contenues dans chacune des trames de données primaires, puis par une étape de mise en correspondance du type de données avec un niveau de priorité.

12. Procédé d'émission de données selon la revendication 11 **caractérisé en ce que** qu'il comprend une étape de contrôle ayant pour fonction de s'assurer, par action sur ladite étape de génération des trames de données primaires, que le débit des trames de données primaires numériques protégées et envoyées sur le canal de communication n'excède pas la bande passante maximale dudit canal de communication.

13. Procédé d'émission de données selon la revendication 12 **caractérisé en ce que** ladite étape de génération de trames de données primaires numériques permet de délivrer un flux de données primaires unique dont le débit est contrôlé par ladite étape de contrôle.

14. Procédé d'émission de données selon la revendication 13 **caractérisé en ce que** ladite étape de contrôle empêche la transmission de certaines trames de données primaires, notamment celles dont le niveau de priorité est faible.

15. Procédé d'émission de données selon la revendication 14 **caractérisé en ce que** ladite étape de génération de trames de données primaires numériques permet de délivrer plusieurs flux de données primaires synchrones ayant chacun un débit différent, ladite étape de contrôle sélectionnant alternativement, dans ces différents flux, des trames de données primaires à protéger contre les erreurs de protection.

16. Produit programme d'ordinateur pour émetteur comportant des moyens de génération de trames de données primaires numériques, pour transmettre à un récepteur via un canal de communication lesdites trames de données primaires numériques protégées contre des erreurs de transmission, ledit programme d'ordinateur comprenant une suite d'instructions de code de programme pour l'exécution des étapes du procédé selon les revendications 9 à 15 lorsque ledit programme est exécuté par un processeur de signal implémenté dans ledit émetteur.
